# EUROPEAN PATENT APPLICATION

(11) **EP 4 776 329 A1**
(43) Date of publication of application: **15.07.2026**
(21) Application number: 24932311.4
(22) Date of filing: 12.09.2024
(51) Int. Cl.: H01L 21/304, C30B 29/40

(54) **INDIUM PHOSPHIDE SUBSTRATE AND SEMICONDUCTOR EPITAXIAL WAFER**

(30) Priority: 29.03.2024 JP 2024058192
(71) Applicant: JX Advanced Metals Corporation, Tokyo 105-8417 (JP)
(72) Inventor: HOSOKI,Wataru, Kitaibaraki-shi, Ibaraki 319-1535 (JP); SUZUKI,Kenji, Kitaibaraki-shi, Ibaraki 319-1535 (JP); HAYASHI,Hideaki, Kitaibaraki-shi, Ibaraki 319-1535 (JP)
(74) Representative: Yeadon IP Limited
(86) International application number: PCT/JP2024/032758
(87) International publication number: WO 2025/203752

(57) **Abstract**

To provide an indium phosphide substrate and a semiconductor epitaxial wafer capable of achieving both improvement in alignment accuracy using an orientation flat and suppression of chipping. The disk-shaped indium phosphide substrate having a main surface, a back surface, and an orientation flat, wherein a chamfer width from the orientation flat on the main surface side is less than 90 µm, and a chamfer width from the orientation flat on the back surface side, a chamfer width from an edge portion on the main surface side, and a chamfer width from an edge portion on the back surface side are each 90 µm or more.

## Description

### FIELD OF THE INVENTION

The present invention relates to an indium phosphide substrate and a semiconductor epitaxial wafer.

### BACKGROUND OF THE INVENTION

Indium phosphide (InP) is a III-V compound semiconductor material composed of indium (In) as a group III element and phosphorus (P) as a group V element. As a semiconductor material, it has a bandgap of 1.35 eV and an electron mobility of up to 5400 cm²/V·s, and exhibits higher electron mobility under a high electric field than other common semiconductor materials such as silicon and gallium arsenide. In addition, its stable crystal structure under normal temperature and pressure is a cubic zinc-blende structure, and it has a larger lattice constant than compound semiconductors such as gallium arsenide (GaAs) and gallium phosphide (GaP).

An ingot of indium phosphide, which serves as a raw material for an indium phosphide substrate, is typically sliced to a predetermined thickness, ground into a desired shape, mechanically polished as necessary, and then subjected to etching and precision polishing to remove polishing debris and damage caused by polishing.

In order to indicate the crystal orientation of an indium phosphide substrate, a commonly used method is an orientation flat method, as disclosed in Patent Literature 1, in which an arc-shaped portion of a predetermined region of a circular substrate (wafer) is cut out to expose a surface having a specific plane orientation. A short linear segment indicating the orientation is referred to as an orientation flat. In wafer processes, various steps are performed with the orientation flat serving as a reference for determining the orientation of the wafer.

### CITATION LIST

### Patent Literatures

[Patent Literature 1] Japanese Unexamined Patent Application Publication No. 2014-028723

### SUMMARY OF THE INVENTION

In wafer processes, the orientation flat serves as a reference for determining the orientation of the wafer. Specifically, for example, two parallel columnar jigs are pressed against the orientation flat, and the orientation flat is used as a reference for determining the orientation of the wafer.

As described above, the orientation flat serves as a reference for determining the orientation of the wafer, and its accuracy (alignment accuracy) is extremely important. However, when the distance from the intersection line between a plane including the orientation flat and a plane including the main surface to the main surface is large due to, for example, shaving of the main surface side of the orientation flat, it becomes difficult to accurately determine the orientation of the wafer. On the other hand, on the back surface side, when the distance from the intersection line between a plane including the orientation flat and a plane including the back surface to the back surface is small, defects such as chipping may occur.

Conventionally, in the edge portion of the wafer including the orientation flat, chamfering having the same shape has been applied to both the main surface side and the back surface side, and there has been a problem that it is difficult to achieve both improvement in alignment accuracy using the orientation flat and suppression of chipping.

The present invention has been made to solve the above problems, and an object of the present invention is to provide an indium phosphide substrate and a semiconductor epitaxial wafer capable of achieving both improvement in alignment accuracy using an orientation flat and suppression of chipping.

The above problems are solved by embodiments of the present invention specified as follows.
(1) A disk-shaped indium phosphide substrate having a main surface, a back surface, and an orientation flat,
   wherein a chamfer width from the orientation flat on the main surface side is less than 90 µm, and
   a chamfer width from the orientation flat on the back surface side, a chamfer width from an edge portion on the main surface side, and a chamfer width from an edge portion on the back surface side are each 90 µm or more.
(2) The indium phosphide substrate according to (1),
   wherein the chamfer width from the orientation flat on the main surface side is less than 60 µm, and
   the chamfer width from the orientation flat on the back surface side, the chamfer width from the edge portion on the main surface side, and the chamfer width from the edge portion on the back surface side are each 100 µm or more.
(3) The indium phosphide substrate according to (1),
   wherein the orientation flat comprises:
   an inclined surface inclined from the back surface; and
   a surface with curvature starting from a position where the inclined surface ends.
(4) The indium phosphide substrate according to any one of (1) to (3),
   wherein the edge portion on the back surface side comprises:
   an inclined surface inclined from the back surface; and
   a surface with curvature starting from a position where the inclined surface ends.
(5) The indium phosphide substrate according to any one of (1) to (4),
   wherein the edge portion on the main surface side comprises:
   an inclined surface inclined from the main surface; and
   a surface with curvature starting from a position where the inclined surface ends.
(6) A semiconductor epitaxial wafer comprising:
   the indium phosphide substrate according to any one of (1) to (5); and
   an epitaxial crystal layer provided on the main surface of the indium phosphide substrate.

According to embodiments of the present invention, it is possible to provide an indium phosphide substrate and a semiconductor epitaxial wafer capable of achieving both improvement in alignment accuracy using an orientation flat and suppression of chipping.

### BRIEF DESCRIPTION OF THE DRAWINGS

FIG. 1 (A) is a schematic cross-sectional view of an indium phosphide substrate (InP substrate) according to an embodiment of the present invention, and (B) is a schematic plan view of the indium phosphide substrate (InP substrate) according to the embodiment of the present invention.
FIG. 2 is an example of a schematic cross-sectional view of the indium phosphide substrate according to the embodiment of the present invention.
FIG. 3 is a schematic cross-sectional view on an orientation flat side of the indium phosphide substrate according to the embodiment of the present invention.
FIG. 4 is a schematic view for explaining a chamfering process according to the embodiment of the present invention.
FIG. 5 is a schematic view showing a state of chamfering an outer peripheral portion of a wafer using a grindstone according to the embodiment of the present invention.

### DETAILED DESCRIPTION OF THE INVENTION

### [Indium Phosphide Substrate]

Hereinafter, a configuration of an indium phosphide substrate according to the present embodiment will be described.

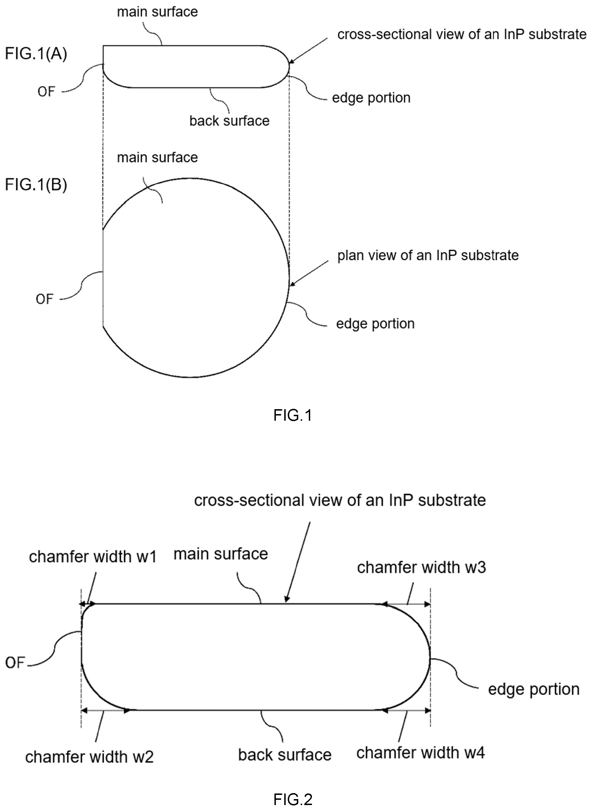

FIG. 1(A) shows a schematic cross-sectional view of the indium phosphide substrate (InP substrate) according to the embodiment of the present invention, and FIG. 1(B) shows a schematic plan view thereof. It should be noted that FIG. 1 is a diagram for understanding a main surface, a back surface, an orientation flat, and an edge portion in the indium phosphide substrate according to the embodiment of the present invention, and does not necessarily represent the actual indium phosphide substrate according to the embodiment of the present invention.

The indium phosphide substrate according to the present embodiment is a disk-shaped substrate having a main surface, a back surface, and an edge portion. A part of the edge portion has an orientation flat (OF) indicating a crystal orientation. The edge portion may further have an index flat (IF) for distinguishing between the main surface and the back surface of the substrate.

The main surface of the indium phosphide substrate may be a surface on which an epitaxial crystal layer is formed. The surface on which the epitaxial crystal layer is formed is a surface on which epitaxial growth is actually performed when the indium phosphide substrate according to the present embodiment is used as a substrate for epitaxial growth in forming a semiconductor device structure.

A maximum diameter of the main surface of the indium phosphide substrate is not particularly limited, but may be from 49 mm to 152.4 mm, and may be from 49 mm to 101 mm.

A thickness of the indium phosphide substrate is not particularly limited, but is preferably from 300 µm to 900 µm, and more preferably from 300 µm to 700 µm. In particular, when a diameter is large, if the thickness of the indium phosphide substrate is less than 300 µm, the substrate may crack, and if it exceeds 900 µm, there may arise a problem that a base material crystal is wasted.

The indium phosphide substrate according to the present embodiment may contain, as a dopant (impurity), Zn (zinc) such that a carrier concentration is 1×10¹⁶ cm⁻³ or more and 1×10¹⁹ cm⁻³ or less, may contain S (sulfur) such that a carrier concentration is 1×10¹⁶ cm⁻³ or more and 1×10¹⁹ cm⁻³ or less, may contain Sn (tin) such that a carrier concentration is 1×10¹⁶ cm⁻³ or more and 1×10¹⁹ cm⁻³ or less, or may contain Fe (iron) such that a carrier concentration is 1×10⁶ cm⁻³ or more and 1×10⁹ cm⁻³ or less.

FIG. 2 shows an example of a schematic cross-sectional view of the indium phosphide substrate according to the embodiment of the present invention. **In** the indium phosphide substrate according to the present embodiment, in a cross section of a wafer edge, as shown in FIG. 2, corners of a rectangular shape are removed (chamfered) to form a curved shape.

**In** the indium phosphide substrate according to the present embodiment, a chamfer width W1 from the orientation flat on the main surface side is controlled to be less than 90 µm. Since the orientation flat serves as a reference for determining an orientation of a wafer, when the chamfer width W1 from the orientation flat on the main surface side is less than 90 µm, alignment accuracy of the wafer based on the orientation flat is improved. The chamfer width W1 from the orientation flat on the main surface side is preferably less than 60 µm, more preferably less than 30 µm, and still more preferably less than 10 µm.

**In** the indium phosphide substrate according to the present embodiment, a chamfer width w2 from the orientation flat on the back surface side, a chamfer width w3 from an edge portion on the main surface side, and a chamfer width w4 from an edge portion on the back surface side are each controlled to be 90 µm or more. When the chamfer width w2 from the orientation flat on the back surface side, the chamfer width w3 from the edge portion on the main surface side, and the chamfer width w4 from the edge portion on the back surface side are each 90 µm or more, occurrence of defects such as chipping can be effectively suppressed. Each of the chamfer width w2, the chamfer width w3, and the chamfer width w4 is preferably 100 µm or more, more preferably 150 µm or more, and still more preferably 200 µm or more. An upper limit of each of the chamfer width w2, the chamfer width w3, and the chamfer width w4 is preferably 600 µm or less, and more preferably 300 µm or less, from a viewpoint of an effective area of the indium phosphide substrate.

The chamfer width w2, the chamfer width w3, and the chamfer width w4 may be the same as each other or may be different from each other. The chamfer width w2 from the orientation flat on the back surface side and the chamfer width w4 from the edge portion on the back surface side are preferably the same from a viewpoint of producing efficiency. The chamfer width w3 from the edge portion on the main surface side and the chamfer width w4 from the edge portion on the back surface side are each formed over an entire circumference of the disk-shaped indium phosphide substrate except for the orientation flat.

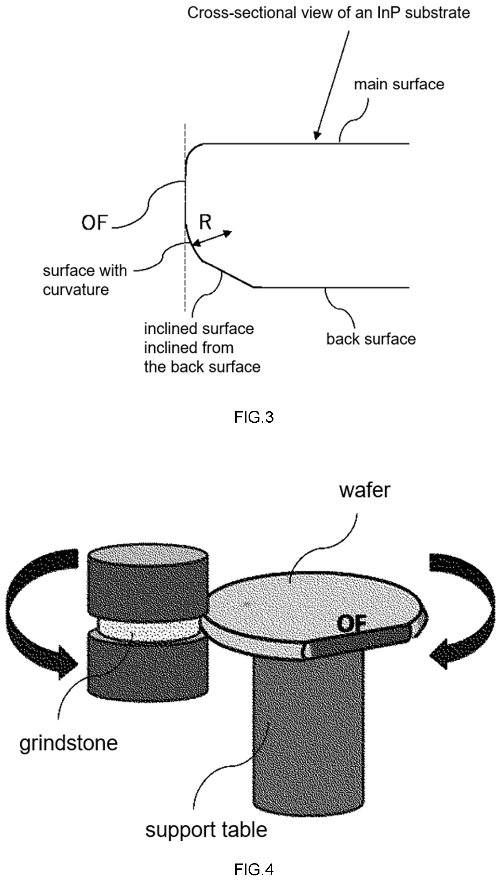

FIG. 3 shows a schematic cross-sectional view on an orientation flat side of the indium phosphide substrate according to the embodiment of the present invention. The orientation flat of the indium phosphide substrate according to the present embodiment preferably has an inclined surface inclined from the back surface and a surface with curvature starting from a position where the inclined surface ends. Here, the "surface with curvature starting from a position where the inclined surface ends" is, as shown in FIG. 3, a surface having curvature extending from the position where the inclined surface inclined from the back surface ends to a central position of the orientation flat, and corresponds to an arc region of the orientation flat. With such a configuration, compared with a case where the entire orientation flat is a surface with curvature, the inclined surface can extend to a position farther from the orientation flat, thereby further suppressing occurrence of chipping.

Further, the edge portion on the back surface side (excluding the orientation flat) of the indium phosphide substrate according to the present embodiment preferably has an inclined surface inclined from the back surface and a surface with curvature starting from a position where the inclined surface ends. The "surface with curvature starting from a position where the inclined surface ends" is as described above with reference to FIG. 3. With such a configuration, compared with a case where the entire edge portion other than the orientation flat is a surface with curvature, the inclined surface can extend to a position farther from the edge portion, thereby further suppressing occurrence of chipping.

The inclined surface inclined from the back surface and the surface with curvature starting from a position where the inclined surface ends in the orientation flat or the edge portion excluding the orientation flat can be appropriately designed as long as the chamfer width from the orientation flat on the back surface side and the chamfer width from the edge portion on the back surface side are each 90 µm or more. For example, the inclined surface inclined from the back surface may occupy 5% to 20% of a thickness of the substrate, and an inclination angle of the surface with curvature starting from a position where the inclined surface ends may be 5° to 30°. A radius of curvature R of the surface with curvature starting from a position where the inclined surface ends is not particularly limited, but may be 100 µm to 300 µm.

Further, the edge portion on the main surface side (excluding the orientation flat) of the indium phosphide substrate according to the present embodiment preferably has an inclined surface inclined from the main surface and a surface with curvature starting from a position where the inclined surface ends. The "surface with curvature starting from a position where the inclined surface ends" is as described above. With such a configuration, compared with a case where the entire edge portion other than the orientation flat on the main surface side is a surface with curvature, the inclined surface can extend to a position farther from the edge portion, thereby further suppressing occurrence of chipping. The inclined surface inclined from the main surface may occupy 5% to 20% of a thickness of the substrate, and an inclination angle thereof may be 5° to 30°. A radius of curvature R of the surface with curvature starting from a position where the inclined surface ends is not particularly limited, but may be 100 µm to 300 µm.

### [Method for Producing Indium Phosphide Substrate]

Next, a method for producing the indium phosphide substrate according to the present embodiment will be described.

First, an indium phosphide ingot is produced by a known method.

Next, the indium phosphide ingot is ground into a cylindrical shape. At this time, an orientation flat (OF) is formed at a predetermined position on an outer peripheral portion of a wafer.

Next, a wafer having a main surface and a back surface is cut out from the ground indium phosphide ingot. At this time, both ends of the crystal of the indium phosphide ingot are cut along a predetermined crystal plane using a wire saw or the like, and a plurality of wafers are cut out to a predetermined thickness.

Next, in order to remove a processed damage layer generated in a cutting step using the wire saw, the wafer after cutting is subjected to double-sided etching with a predetermined etching solution (primary etching). The wafer can be etched by immersing an entire wafer in the etching solution. The primary etching may be omitted.

Next, chamfering of an outer peripheral portion of the wafer is performed. The chamfering of the outer peripheral portion of the wafer is performed by grinding the outer peripheral portion of the wafer with a grindstone rotating in a direction opposite to that of the wafer while rotating the wafer in a state where the wafer is placed on a support table and held by suction, thereby processing the wafer into a desired shape, as shown in FIG. 4. As the grindstone, a grindstone having a grit size of #600 to #2000 is preferably used.

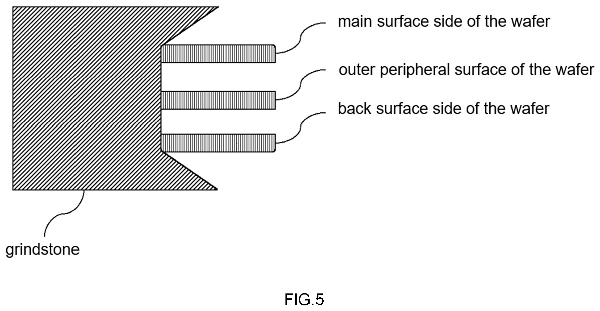

FIG. 5 is a schematic view showing a state of chamfering an outer peripheral portion of the wafer using the grindstone. FIG. 5 is an illustrative diagram showing chamfering on the main surface side, grinding of the outer peripheral portion, and chamfering on the back surface side. As shown in FIG. 5, a side surface of a contact portion of the grindstone with the wafer has a central flat surface and inclined surfaces extending upward and downward from the flat surface, and the chamfering on the main surface side and the back surface side of the wafer is performed using the inclined surfaces. The grindstone is fixed in a vertical direction, and the wafer is moved up and down by the support table to grind an edge portion of the rotating wafer. **In** the orientation flat and the edge portion other than the orientation flat, the chamfer width can be finely controlled by slightly changing a contact position of the wafer relative to the inclined surfaces of the grindstone. Accordingly, the chamfer width W1 from the orientation flat on the main surface side can be controlled to be less than 90 µm, and the chamfer width W2 from the orientation flat on the back surface side, the chamfer width W3 from the edge portion on the main surface side, and the chamfer width W4 from the edge portion on the back surface side can each be controlled to be 90 µm or more. Further, the orientation flat or the edge portion other than the orientation flat can be processed into a shape having an inclined surface inclined from the back surface and a surface with curvature starting from a position where the inclined surface ends.

After the chamfering, at least one surface of the wafer, preferably both surfaces, may be polished. The polishing step is also referred to as a lapping step, and by polishing with a predetermined polishing agent, irregularities on the wafer surface are removed while maintaining flatness of the wafer.

Subsequently, the wafer is subjected to double-sided etching with a predetermined etching solution (secondary etching). The wafer can be etched by immersing the entire wafer in the etching solution.

Next, the main surface of the wafer is polished with a polishing material for mirror finishing to obtain a mirror surface.

Next, cleaning is performed, thereby producing the indium phosphide substrate according to the present embodiment.

### [Semiconductor Epitaxial Wafer]

A semiconductor epitaxial wafer can be produced by forming an epitaxial crystal layer by epitaxially growing a semiconductor thin film on the main surface of the indium phosphide substrate according to the present embodiment by a known method. For example, a HEMT structure in which an InAlAs buffer layer, an InGaAs channel layer, an InAlAs spacer layer, and an InP electron supply layer are epitaxially grown on the main surface of the indium phosphide substrate may be formed. In producing such a semiconductor epitaxial wafer having the HEMT structure, generally, the indium phosphide substrate having a mirror-finished surface is subjected to an etching treatment using an etching solution such as sulfuric acid/hydrogen peroxide to remove impurities such as silicon (Si) attached to the substrate surface. After the etching treatment, the back surface of the indium phosphide substrate is brought into contact with a susceptor to support the substrate, and an epitaxial film is formed on the main surface of the indium phosphide substrate by molecular beam epitaxy (MBE: Molecular Beam Epitaxy) or metal organic chemical vapor deposition (MOCVD: Metal Organic Chemical Vapor Deposition).

### EXAMPLES

The following examples are provided to better understand the present invention and its advantages, but the present invention is not limited to these examples.

### (Example 1)

First, an indium phosphide single-crystal ingot grown to a predetermined diameter was prepared.

Next, an outer periphery of the indium phosphide single-crystal ingot was ground to form a cylindrical shape. At this time, an orientation flat (OF) was formed at a predetermined position on an outer peripheral portion of a wafer.

Next, a wafer having a main surface and a back surface was cut out from the ground indium phosphide ingot. At this time, both ends of the crystal of the indium phosphide ingot were cut along a predetermined crystal plane using a wire saw, and a plurality of wafers were cut out to a predetermined thickness. In the step of cutting out the wafers, a wire was reciprocated while continuously feeding a new wire, and the indium phosphide was moved toward the wire saw. The wafer prepared here had a wafer diameter of 51.8 mm and a wafer thickness of 350 µm.

Next, in order to remove a processed damage layer generated in a cutting step using the wire saw, the wafer after cutting was subjected to double-sided etching using a mixed solution of an 85 mass% phosphoric acid aqueous solution and a 30 mass% hydrogen peroxide aqueous solution (primary etching). The wafer was etched by immersing an entire wafer in the etching solution.

Next, chamfering of an outer peripheral portion of the wafer was performed. The chamfering of the outer peripheral portion of the wafer was performed by grinding the outer peripheral portion of the wafer with a grindstone rotating in a direction opposite to that of the wafer while rotating the wafer in a state where the wafer was placed on a support table and held by suction, as shown in FIG. 4. A side surface of a contact portion of the grindstone with the wafer had, as shown in FIG. 5, a central flat surface and inclined surfaces extending upward and downward from the flat surface, and chamfering on the main surface side and the back surface side of the wafer was performed using the inclined surfaces. A grit size of the grindstone used was #1200. Subsequently, chamfering of the OF portion was performed. In the case of chamfering the OF portion, the chamfering was performed by controlling and programming a distance between the grindstone and the wafer and a vertical position of the support table of the wafer so that a linear OF portion of the wafer was always in contact with the rotating grindstone, and sequence control was carried out. In the chamfering of the OF portion, the grit size of the grindstone was set to #1200. By performing chamfering of the linear OF portion such that the grindstone and the OF portion were always in contact and controlling an amount of grinding at that time with good controllability, the chamfer width W1 was controlled.

Next, both surfaces of the wafer after chamfering were polished (lapped). At this time, by polishing with a polishing agent, irregularities on the wafer surface were removed while maintaining flatness of the wafer.

Next, the wafer after polishing was subjected to etching from both surfaces using a mixed solution of an 85 mass% phosphoric acid aqueous solution, a 30 mass% hydrogen peroxide aqueous solution, and ultrapure water so that a total etching amount was 8 µm to 15 µm (secondary etching). The wafer was etched by immersing the entire wafer in the etching solution.

Next, a main surface of the wafer was polished with a polishing material for mirror finishing to obtain a mirror surface, followed by cleaning, thereby producing a disk-shaped indium phosphide substrate having an orientation flat according to Example 1. The indium phosphide substrate according to Example 1 had a maximum diameter of the main surface of 50.8 mm and a thickness of 350 µm.

### (Comparative Example 1)

As Comparative Example 1, a disk-shaped indium phosphide substrate having an orientation flat was produced in the same manner as in Example 1 except that, in the chamfering step of the outer peripheral portion of the wafer, chamfer widths were controlled to values shown in Table 1.

### (Evaluation)

Side surfaces of the indium phosphide substrates according to Example 1 and Comparative Example 1 were measured at a magnification of 2 using a wafer edge profile measuring apparatus (Wafer Edge Profile Checker, model EPRO-212EN V4, manufactured by SPEED FAM Co., Ltd.). Measurement results are shown in Table 1.

**Table 1**

| | Chamfer width from OF on main surface side | Chamfer width from OF on back surface side | Chamfer width from edge portion on main surface side | Chamfer width from edge portion on back surface side |
|---|---|---|---|---|
| Example 1 | 33 µm | 197 µm | 191 µm | 220 µm |
| Comparative Example 1 | 213 µm | 223 µm | 214 µm | 225 µm |

Next, alignment is performed using the orientation flat of the indium phosphide substrates according to Example 1 and Comparative Example 1 by using an optical microscope from above the substrates. As a result, it is considered that, in the indium phosphide substrate according to Example 1, a placement position of the substrate can be accurately fixed (aligned). On the other hand, in the indium phosphide substrate according to Comparative Example 1, even when alignment is performed using an optical microscope, since the chamfer width of the orientation flat portion is large, it is difficult to accurately focus on an end portion of the orientation flat, and it is considered that the placement position of the substrate cannot be accurately fixed (aligned).

Accordingly, it is understood that, when the chamfer width from the orientation flat on the main surface side is less than 90 µm as in Example 1, alignment accuracy of the wafer using the orientation flat is improved, whereas when the chamfer width from the orientation flat on the main surface side is 90 µm or more as in Comparative Example 1, alignment accuracy of the wafer using the orientation flat is reduced.

Further, in the indium phosphide substrate according to Example 1, since the chamfer width W2 from the orientation flat on the back surface side, the chamfer width W3 from the edge portion on the main surface side, and the chamfer width W4 from the edge portion on the back surface side are each 90 µm or more, occurrence of chipping is effectively suppressed.

According to an embodiment of the present invention, it is possible to achieve both improvement in alignment accuracy of a wafer using an orientation flat and suppression of chipping. Since the InP substrate is used as a material for light-emitting and light-receiving devices for optical communication, the embodiment of the present invention may contribute to advancement of optical communication technology. Accordingly, the embodiment of the present invention may contribute to Goal 9 of the Sustainable Development Goals (SDGs) led by the United Nations, namely, "Build resilient infrastructure, promote inclusive and sustainable industrialization and foster innovation."

## Claims

1. A disk-shaped indium phosphide substrate having a main surface, a back surface, and an orientation flat,
wherein a chamfer width from the orientation flat on the main surface side is less than 90 µm, and
a chamfer width from the orientation flat on the back surface side, a chamfer width from an edge portion on the main surface side, and a chamfer width from an edge portion on the back surface side are each 90 µm or more.

2. The indium phosphide substrate according to claim 1,
wherein the chamfer width from the orientation flat on the main surface side is less than 60 µm, and
the chamfer width from the orientation flat on the back surface side, the chamfer width from the edge portion on the main surface side, and the chamfer width from the edge portion on the back surface side are each 100 µm or more.

3. The indium phosphide substrate according to claim 1,
wherein the orientation flat comprises:
an inclined surface inclined from the back surface; and
a surface with curvature starting from a position where the inclined surface ends.

4. The indium phosphide substrate according to claim 1,
wherein the edge portion on the back surface side comprises:
an inclined surface inclined from the back surface; and
a surface with curvature starting from a position where the inclined surface ends.

5. The indium phosphide substrate according to claim 1,
wherein the edge portion on the main surface side comprises:
an inclined surface inclined from the main surface; and
a surface with curvature starting from a position where the inclined surface ends.

6. A semiconductor epitaxial wafer comprising:
the indium phosphide substrate according to any one of claims 1 to 5; and
an epitaxial crystal layer provided on the main surface of the indium phosphide substrate.
